# FASCICULE DE BREVET EUROPEEN

(11) **EP 0 658 391 B1**
(45) Date de publication et mention de la délivrance du brevet: **08.04.1998**
(21) Numéro de dépôt: 94402784.6
(22) Date de dépôt: 05.12.1994
(51) Int. Cl.: B23K 1/20, C23G 5/00, B23K 35/38

(54) **Procédé et dispositif de fluxage par voie sèche de surfaces métalliques avant brassage ou étamage**
Verfahren, Vorrichtung zum Trockenfluxen von metallischen Flächen vor dem Löten
Process, apparatus for dry reflowing metallic surfaces, before brazing them

(30) Priorité: 15.12.1993 FR 9315112
(43) Date de publication de la demande: 21.06.1995
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Sindzingre, Thierry, F- 94230 Cachan (FR); Rabia, Stéphane 14 Rés. Parc Château de Courcelles, F- 91190 Gif Sur Yvette (FR)
(74) Mandataire: Le Moenner, Gabriel

(56) Documents cités:
- EP-A- 0 371 693
- EP-A- 0 427 020
- EP-A- 0 552 096
- US-A- 5 236 512

## Description

La présente invention concerne l'opération de fluxage de surfaces métalliques intervenant généralement avant des opérations de brasage ou d'étamage en électronique. Elle s'applique ainsi notamment au fluxage intervenant avant les opérations :
- de brasage de composants sur circuit (qu'il s'agisse de composants insérés ou de composants montés en surface),
- de brasage de bandes de contacts sur supports électroniques, permettant la connexion du support en question sur un autre support (on peut considérer ici l'exemple d'un circuit hybride ou d'un circuit imprimé que l'on va insérer grâce à ces contacts dans un circuit imprimé, ou encore un circuit hybride ou imprimé que l'on va pouvoir enficher, grâce à ce peigne, dans un connecteur),
- de brasage de circuits dans des fonds de boîtiers (intervenant lors de l'encapsulation de tels circuits),
- de brasage intervenant lors de procédures de fermeture de boîtiers d'encapsulation,
- de brasage de puces nues sur supports tels que circuit imprimé, circuit hybrides ou encore substrats d'interconnexion multicouches tels que les substrats couramment appelés MCM (Multi Chip Modules),
- d'étamage de terminaisons de composants électroniques.

Le rôle du fluxage est alors de nettoyer les surfaces métalliques à braser ou étamer (dégraissage, désoxydation, décontamination de couches adsorbées..), ceci dans le but de faciliter le mouillage ultérieur de ces surfaces par la soudure.

Cette opération de fluxage est, le plus couramment, pratiquée à l'aide de flux chimiques, souvent obtenus à partir de bases résineuses, complétées notamment par des composés acides. Après brasage, demeurent sur la pièce des résidus de flux, obligeant souvent le fabricant à effectuer une opération de nettoyage, le plus souvent avec des solvants chlorés, opération de nettoyage qui s'avère .particulièrement problématique dans le cas des puces nues du fait de leur grande fragilité, mais qui est aussi très controversée, dans le contexte du "Protocole de Montréal" où ces solvants font l'objet d'une réglementation très stricte, voir pour certains, selon les pays, d'une interdiction pure et simple.

Deux des méthodes les plus couramment utilisées pour effectuer l'opération de brasage sont appelées "brasage à la vague" et "brasage par refusion".

Dans le premier cas (machines de brasage à la vague), la conception de ces machines est telle que les pièces à braser ou à étamer sont amenées en contact avec une ou plusieurs vagues de soudure liquide obtenues par circulation du bain de soudure contenu dans un bac, au travers d'une buse.

Au préalable, les pièces (par exemple les circuits sur lesquels ont été reportés les composants ou encore des composants à étamer), ont généralement été fluxés dans une zone amont de la machine, à l'aide d'un spray de flux ou d'une mousse de flux ("foam"), l'opération de fluxage étant suivie d'une opération dite de préchauffage qui est pratiquée pour activer les flux précédemment déposés sur le circuit et pour préchauffer les circuits ou les composants avant leur arrivée dans la zone chaude de brasage. Un système de convoyage est présent pour déplacer les pièces d'une zone à l'autre de la machine.

Ces machines sont traditionnellement ouvertes à l'atmosphère d'air ambiant.

Dans le cas du second type de méthode (brasage par refusion), qui regroupe d'ailleurs sous ce vocable plusieurs techniques, on utilise non plus un bain de soudure liquide mais une pâte à braser contenant l'alliage de brasure (formulation de pâte dans laquelle le flux est inclus) qui est déposée sur le support (circuit avant dépôt des composants, bords du boîtier à fermer ou encore fond de boîtier), et à laquelle est apportée une certaine quantité de chaleur permettant d'obtenir la fusion de l'alliage métallique. Le plus souvent, ce transfert thermique est réalisé dans un four continu.

Dans un cas comme dans l'autre (vague ou refusion), se pose le problème de l'opération de nettoyage après brasage, précédemment évoquée, qui utilise le plus souvent des solvants chlorés, fortement réglementés par le protocole de Montréal et ses révisions ultérieures.

Ce problème a donc été à l'origine de nombreux efforts de recherche dans le monde ces dernières années pour essayer de proposer une solution de remplacement à l'utilisation de ces composés.

Parmi les solutions envisagées, on peut citer le nettoyage plasma des surfaces avant brasage, évitant de ce fait l'utilisation de flux chimiques et donc la nécessité même d'une opération de nettoyage en aval. Les mélanges envisagés mettaient notamment en oeuvre de l'hydrogène.

On peut citer dans ce domaine le document EP-A-0427020, qui propose d'effectuer un traitement des pièces d'assemblage à braser à l'aide d'un plasma d'un gaz de procédé, en recommandant l'utilisation de basses pressions pour ce traitement, "dans le but d'éviter un endommagement thermique des pièces d'assemblage". Tous les exemples donnés, en relation avec les figures fournies, concernent des conditions de pression variant dans l'intervalle 30-100 Pa.

La même remarque peut être effectuée à propos du document EP-A-0371693 qui concerne un procédé de nettoyage de surfaces métalliques avant brasage, par plasma micro-ondes contenant de l'hydrogène. Ici encore, il est recommandé (et illustré au niveau de l'ensemble des exemples) d'utiliser des basses pressions "pour permettre de limiter le niveau d'oxygène résiduel dans le plasma".

Cette unanimité dans l'utilisation de conditions de basses pressions pour réaliser ces nettoyages plasma, malgré les inconvénients liés notamment au coût d'obtention de telles pressions ou encore à la difficulté d'implantation des infrastructures correspondantes dans une chaîne de production, est sans aucun doute liée à la difficulté technique et technologique d'obtention de plasmas à pression atmosphérique donnant des performances comparables à ce qui est traditionnellement obtenu à basse pression.

Dans ce contexte, la demanderesse, dans le document FR-A-2,697,456, dont le contenu est ici intégré pour référence, a récemment proposé un procédé de fluxage plasma de surfaces métalliques avant brasage, à la pression atmosphérique, utilisant pour créer le plasma une source de micro-ondes ou encore une décharge couronne transférée via des lumières placées de façon adéquate dans une couche diélectrique placée au dessus de la pièce à traiter. Si cette demande apporte une réponse intéressante au problème considéré, la Demanderesse a mis en évidence le fait que le procédé proposé pourrait être amélioré, notamment en ce qui concerne :
- son rendement (rapport de la puissance introduite pour créer le plasma à la densité d'espèces produites qui interagissent effectivement avec le support à traiter), ou encore la densité d'énergie obtenue (dans le cas de la décharge couronne, elle n'atteint que quelques watts (W) par unité de surface de diélectrique), qui si ils étaient accrus pourraient permettre des temps de traitement plus courts,
- mais aussi du fait de facteurs "géométriques" limitants : dans le cas de la décharge couronne, la distance électrode/échantillon est tout à fait critique et doit être maintenue très faible, ce qui peut poser problème dans le cas de substrats dont le relief est relativement tourmenté; dans le cas de la décharge micro-ondes, elle donne lieu à la formation d'un spot plasmagène, de dimensions déterminées et limitées par la source plasma,
- par ailleurs, un plasma tel que celui créé dans ce document, contient par définition des espèces ioniques et des électrons (donc des espèces électriquement chargées) dont l'emploi est toujours délicat sur des composants électroniques.

Le document U.S.-A-5,236,512 représente un autre exemple de l'Etat de la Technique s'intéressant aux traitements de décapage de surface par mise en contact de la surface à traiter, au sein d'une chambre réactionnelle close, avec un plasma (atomes excités, ions, électrons), la surface à nettoyer, ainsi que le système d'électrodes servant à créer le plasma étant tous deux situés au sein de la chambre réactionnelle.

En parallèle, la demanderesse a récemment proposé, dans le document FR-A-2,692,730, dont le contenu est supposé intégré ici pour référence, un dispositif de formation de molécules gazeuses excitées ou instables, fonctionnant sensiblement à la pression atmosphérique. Dans ce contexte, la présente invention a pour objet de proposer un procédé amélioré de fluxage par voie sèche de surfaces métalliques avant brasage ou étammage, permettant :
- d'opérer sensiblement à pression atmosphérique,
- une grande flexibilité de distance entre l'objet à traiter et le dispositif utilisé pour effectuer ce traitement,
- d'éviter le contacts des pièces avec des espèces chargées,
- d'offrir une densité énergétique améliorée, permettant d'atteindre une vitesse de traitement accrue.

Pour ce faire, l'invention propose le procédé de fluxage par voie sèche d'une surface métallique avant brasage ou étamage, tel que défini dans la revendication 1.

On entend par l'expression "surface métallique" selon l'invention, tout type de surface métallique pouvant intervenir dans de telles opérations de brasage ou d'étamage, qu'elle soit par exemple en acier, cuivre, aluminium, étain, plomb, étainplomb, étain-plomb-argent, ou encore alliages tels que Kovar, cette liste n'étant bien entendue qu'indicative, pas limitative.

L'"alliage" de brasage ou d'étamage selon l'invention sera constitué par toute composition que l'on peut envisager pour de telles opérations (par exemple de brasage par refusion ou dans une machine de brasage à la vague, ou encore d'étamage à la vague), telles que par exemple Sn-Pb, Sn-Pb-Ag, Pb-In etc..

On entend par l'expression "pression voisine de la pression atmosphérique" selon l'invention, une pression se situant avantageusement dans l'intervalle [0,1 x 10⁵ Pa, 3 x 10⁵ Pa].

On entend par l'expression "espèces électriquement chargées" selon l'invention, des ions ou des électrons. L'atmosphère de traitement selon l'invention se distingue donc des atmosphères plasma classiques par le fait qu'elle est substantiellement dépourvue d'espèces électriquement chargées, c'est à dire d'ions où d'électrons.

L'atmosphère de traitement est avantageusement obtenue à partir d'un mélange gazeux primaire et le cas échéant d'un mélange gazeux adjacent, le mélange gazeux primaire étant obtenu à la sortie de gaz d'au moins un appareil de formation d'espèces gazeuses excitées ou instables dans lequel a été transformé un mélange gazeux initial comprenant un gaz inerte et/ou un gaz réducteur et/ou un gaz oxydant, le mélange gazeux adjacent n'ayant pas transité par l'appareil.

On peut qualifier cette configuration de "post-décharge" puisque la composante primaire de l'atmosphère de traitement, qui comprend des espèces gazeuses excitées ou instables, est obtenue en sortie d' appareil, ce qui assure l'absence substantielle de toute espèce électriquement chargée dans cette composante primaire. La composante adjacente de l'atmosphère de traitement, qui n'a pas transité par l'appareil, en est à fortiori dépourvue.

Par ailleurs, cette configuration permet de nettement séparer le lieu de la génération de la composante primaire de l'atmosphère du lieu de son utilisation, ce qui présente un avantage non négligeable en terme de pollution de l'appareil (éviter que les dégagements divers résultant de l'opération de fluxage de la surface n'aillent polluer l'intérieur de l'appareil, par exemple ses électrodes). Enfin, la pièce, qui n'est pas traitée au sein de l'appareil (par exemple au sein de la décharge entre les électrodes), bénéficie d'une bien meilleure fléxibilité sur l'aspect "distance" évoqué plus haut.

Le gaz inerte peut par exemple consister en de l'azote, de l'argon, de l'hélium ou un mélange de tels gaz inertes. Le gaz réducteur peut par exemple consister en de l'hydrogène, du CH₄ ou encore de l'ammoniac ou un mélange de tels gaz réducteurs. Le gaz oxydant peut quant à lui par exemple consister en de l'oxygène, ou du CO₂, ou encore du N₂O, H₂O, ou un mélange de tels gaz oxydants. La liste de gaz donnés dans chaque catégorie n'étant bien entendu qu'indicative, nullement limitative.

L' appareil selon l'invention est constitué par tout dispositif permettant "d'exciter" un mélange gazeux initial, pour obtenir, en sortie de gaz du dit appareil, un autre mélange gazeux comportant des espèces instables ou excitées, ce dernier mélange gazeux étant substantiellement dépourvu d'espèces électriquement chargées. Un telle excitation pourra par exemple être obtenue par une décharge électrique, par exemple du type décharge couronne.

Comme il apparaîtra clairement à l'homme du métier, le procédé de fluxage selon l'invention permet d'effectuer le traitement à l'aide du mélange primaire obtenu en sortie de gaz d'un seul appareil, ou de plusieurs appareils placés en parallèle sur la largeur de la pièce à traiter, ou encore successivement à l'aide des mélanges primaires obtenus en sorties de gaz de plusieurs appareils placés en série.

De même, comme il apparaîtra clairement à l'homme du métier, le procédé selon l'invention s'applique selon les besoins exprimés par l'utilisateur tant au traitement d'une seule des faces de la pièce à traiter, qu'au cas où l'on doit fluxer la pièce sur ses deux faces. Dans ce dernier cas, il conviendra de disposer les appareils requis en regard de chaque face de la pièce.

Le mélange adjacent, selon l'invention, pourra être constitué de tout gaz ou mélange de gaz, par exemple d'un gaz inerte ou mélange de gaz inertes permettant de maintenir, le cas échéant, une atmosphère protectrice autour des échantillons, ou encore d'un gaz réducteur ou d'un gaz oxydant, voire d'un mélange de gaz appartenant à l'une de ces trois catégories.

Selon un des aspects de l'invention, le mélange adjacent contient du silane SiH₄. La présence d'un tel mélange adjacent contenant du silane est avantageusement utilisée pour son action réductrice vis-à-vis de certains oxydes métalliques présents à la surface de la pièce à traiter, mais aussi, selon le mélange gazeux initial utilisé, comme "guetter" (ou piègeur) d'oxygène, c'est-à-dire dans son interaction avec l'oxygène résiduel de l'atmosphère présente au-dessus de la pièce à traiter, dans le but de réduire à un minimum ce niveau d'oxygène résiduel.

Selon un autre aspect de l'invention, la surface à traiter est portée à une température comprise entre la température ambiante et la température de fusion de l'alliage utilisé pour effectuer l'opération de brasage ou étamage ultérieure. Cette borne haute dépendra donc de l'alliage utilisé, elle se situera par exemple au voisinage de 180 °C dans le cas des alliages Sn63-Pb37 ou Sn62-Pb36-Ag2 utilisés classiquement.

Selon un des aspects de l'invention, la pièce comportant la ou les surfaces métalliques à traiter est amenée en regard de la sortie de gaz de l'appareil, le cas échéant, en regard des sorties de gaz de plusieurs appareils placés en parallèle sur la largeur de la pièce et/ou successivement en regard des sorties de gaz de plusieurs appareils placés en série, par un système de convoyage traversant un espace intérieur délimité par une structure de capotage (par exemple un tunnel ou un ensemble de capotages élémentaires), isolée de l'atmosphère environnante, la dite structure étant raccordée de façon étanche au dit appareil ou incluant ledit appareil.

La même remarque déja effectuée plus haut s'applique ici, sur le traitement en double faces (ici encore, il suffit de mettre en oeuvre les appareils requis, en nombre et en disposition, en regard de chaque face de la pièce).

Selon une des mises en oeuvre de l'invention, l'appareil, dans lequel est transformé ledit mélange gazeux initial est le siège d'une décharge électrique créée entre une première électrode et une seconde électrode , une couche d'un matériau diélectrique étant disposée sur la surface d'au moins une des électrodes, en regard de l'autre électrode, le mélange gazeux initial traversant la décharge transversalement aux électrodes.

L'énergie mise en oeuvre dans l'appareil, ramenée à l'unité de surface de diélectrique sera alors avantageusement supérieure à un 1W/cm², préférentiellement supérieure à 10W/cm^{2.}

Selon une des mises en oeuvre de l'invention, on réalise un zonage de l'atmosphère de traitement rencontrée successivement par la pièce à traiter le long du convoyeur, de la façon suivante :
a) au moins un des appareils de formation d'espèces gazeuses excitées ou instables, transforme un mélange gazeux initial différent de celui transformé par l'appareil le précédant dans la dite structure, et/ou
b) le mélange gazeux adjacent mis en oeuvre au niveau d'au moins un des appareils de formation d'espèces gazeuses excitées ou instables est différent de celui mis en oeuvre au niveau de l'appareil le précédant dans la dite structure.

Selon une des mises en oeuvre de l'invention, les étapes a) et b) ci-dessus pourront concerner un même appareil.

On pourra ainsi par exemple utiliser des mélanges de pouvoir réducteur croissant, d'un appareil à l'autre.

Selon un des aspects de l'invention, en sortie de la dite structure, la pièce entre dans une machine où est effectuée la dite opération de brasage ou d'étamage, la pièce étant, le cas échéant, entre la sortie de la dite structure et l'entrée de la dite machine, maintenue sous atmosphère protectrice. On entend alors par atmosphère protectrice, une atmosphère essentiellement inerte, dont la concentration résiduelle d'oxygène n'excède par quelques centaines de ppm, voire 100 ppm.

Selon un autre aspect de l'invention, la dite opération de brasage ou d'étamage est réalisée au sein de la structure de capotage même (par exemple un tunnel), en aval de l'appareil.

L'invention concerne aussi un dispositif de fluxage par voie sèche d'une surface métallique avant brasage ou étamage, tel que défini dans la revendication 13.

Ladite structure de capotage est munie le cas échéant d'au moins un moyen d'injection d'un gaz dit adjacent n'ayant pas transité par le ou les dits appareils, le dispositif comprenant de plus, le cas échéant, un moyen de chauffage des pièces à traiter.

D'autres caractéristiques et avantages de la présente invention ressortiront de la description suivante de modes de réalisation donnés à titre illustratif, faite en relation avec les dessins annexés, sur lesquels :
- la figure 1 est une vue schématique d'une installation convenant pour la mise en oeuvre du procédé selon l'invention.
- la figure 2 représente schématiquement en coupe un exemple d'appareil de formation d'espèces gazeuses excitées ou instables convenant pour la mise en oeuvre du procédé selon l'invention.

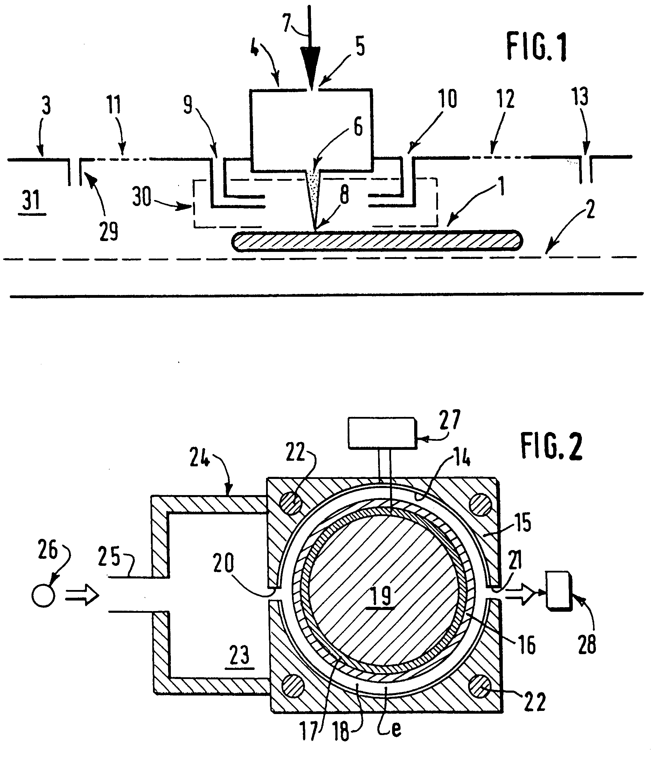

On reconnaît sur la figure 1, la présence d'une pièce 1, comportant les surfaces métalliques à fluxer, amenée grâce à un tapis de convoyage 2, en regard de la sortie de gaz 6 d'un appareil 4 de formation d'espèces gazeuses excitées ou instables.

Le système de convoyage 2 traverse un espace intérieur 31, délimité par un tunnel 3, raccordé avantageusement de façon étanche à l'appareil 4.

On a schématisé en 8 le mélange gazeux primaire obtenu en sortie 6 de l'appareil. Le mélange gazeux primaire 8 est obtenu à partir d'un mélange gazeux initial 7 entrant dans l'appareil au niveau de son entrée de gaz 5.

On note aussi sur le mode de réalisation représenté sur la figure 1 la présence d'entrées de mélanges gazeux adjacents 9, 10. L'atmosphère gazeuse obtenue à partir des mélanges gazeux adjacents 9, 10 et du mélange gazeux primaire 8 constitue l'atmosphère 30 de traitement selon l'invention.

On note sur le mode de réalisation représenté sur la figure 1, la présence d'appareils de formation d'espèces gazeuses excitées ou instables supplémentaires, non représentés, en 11 et 12, en série avec le premier appareil 4 et que rencontre successivement la pièce 1.

L'installation se complète alors par d'autres entrées de mélange de gaz adjacent telles que celles représentées en 13 et 29.

L'installation est par ailleurs pourvue, le cas échéant, d'un moyen de chauffage de la pièce 1, non représenté sur la figure 1. On pourra par exemple envisager, pour ce moyen de chauffage, des lampes infra-rouge présentes dans le tunnel, ou un chauffage par convection (parois chaudes du tunnel) ou encore le fait que la pièce soit posée sur un porte-substrat chauffant.

Comme représenté sur le mode de réalisation de la figure 2, l'appareil pour ce mode de réalisation est de géométrie cylindrique, il comprend une première électrode tubulaire 14, formée par exemple par une face interne d'un bloc métallique 15, et dans laquelle est disposé concentriquement un ensemble d'un tube en matériau diélectrique 16, par exemple en céramique, sur la face interne duquel est déposée, par métallisation, une deuxième électrode 17, exagérément épaissie sur la figure 2 pour une meilleure compréhension.

L'ensemble du diélectrique 16 et de la deuxième électrode 17 défini ainsi, avec la première électrode 14, un passage tubulaire de gaz 18, et, intérieurement, un volume interne 19 dans lequel on fait circuler un réfrigérant, avantageusement un Fréon pour son caractère électronégatif ou encore de l'eau permutée. Le passage de gaz interne 18 a une extension axiale inférieure à 1 m, typiquement inférieure à 50 cm, et son épaisseur radiale e n'excède pas 3 mm et est typiquement inférieure à 2,5 mm.

Le bloc 15 comporte, diamétralement opposées, deux fentes longitudinales 20 et 21 formant respectivement l'entrée du gaz initial à exciter dans le passage 18 et la sortie du flux de gaz primaire comportant des espèces gazeuses excitées ou instables.

Les fentes 20 et 21 s'étendent sur toute la longueur axiale de la cavité 18 et ont une hauteur qui pour le mode de réalisation représenté figure 2, n'excède pas l'épaisseur e et est typiquement sensiblement identique à cette dernière. Le corps 15 comporte avantageusement, à la périphérie de la première électrode 14, une pluralité de conduits 22 pour le passage d'un réfrigérant, par exemple de l'eau. L'entrée de gaz 20 communique avec une chambre ou plénum d'homogénéisation 23 formée dans un boîtier 24 accolé au bloc 15 et comportant une tubulure 25 d'amenée de gaz initial, à une pression comprise entre 0,1 x 10⁵Pa et 3 x 10⁵ Pa, en provenance d'une source de gaz initial 26. Les électrodes 14 et 17 sont reliées à un générateur électrique haute tension et haute fréquence 27, fonctionnant à une fréquence avantageusement supérieure à 15 kHz, délivrant une puissance par exemple de l'ordre de 10 kW. On pourra d'ailleurs avantageusement exprimer cette puissance délivrée par le générateur en la ramenant à la surface de diélectrique.

Le flux gazeux contenant les espèces excitées, disponible à la sortie de gaz 21, est adressé à un poste utilisateur 28, pour le fluxage de surfaces métalliques.

Une installation telle que celle décrite en relation avec la figure 1, intégrant un unique appareil 4, tel que celui décrit en relation avec la figure 2, a été utilisée pour la réalisation de 4 exemples de mise en oeuvre de l'invention rapportés ci-dessous, complétés par deux exemples comparatifs.

Pour le premier exemple de mise en oeuvre, des échantillons de cuivre de qualité électronique, de dimensions 0.3 x 50 x 50 mm ont tout d'abord été décapés à l'aide d'une solution à 20 % d'acide nitrique dans l'eau, avant de subir une oxydation thermique (par chauffage durant 5 mn sous air à 200 °C). Ce traitement d'oxydation donnant lieu à l'apparition d'une nette couche violacée à la surface des échantillons de cuivre, ces substrats étant, avant oxydation, naturellement d'une couleur "saumon".

Dans un second temps, les échantillons ont été traités à l'aide de l'installation précédemment décrite, dans les conditions suivantes :
- puissance mise en oeuvre (délivrée par le générateur): 1000 W, correspondant à une puissance de 15 W/cm² de diélectrique,
- mélange gazeux initial comprenant 65 % d'hydrogène dans l'azote (obtenu en mettant en oeuvre des débits de 10 m³/h d'azote et 18 m³/h d'hydrogène),
- mélange gazeux adjacent : de l'azote permettant de maintenir la pression partielle d'oxygène à l'intérieur du tunnel en dessous de 20 ppm,
- l'échantillon était porté à une température de 150 °C,
- traitement en un seul passage : l'échantillon défilant, grâce au convoyeur 2, à une vitesse de 2 mm/s,
- traitement effectué sensiblement à la pression atmosphérique,
- distance entre l'échantillon à traiter et la sortie de gaz de l'appareil : 10 mm.

L'observation des échantillons traités selon ce mode opératoire a montré un excellent état de surface, les échantillons retrouvant leur couleur saumon initiale caractéristique.

Pour un second exemple, comparatif, on a utilisé l'installation de fluxage plasma par décharge micro-ondes décrite dans le document FR-A-2,697,456 au nom de la Demanderesse déja évoqué plus haut. Des échantillons de cuivre de même qualité, de dimensions 0,3 x 20 x 20 mm ont été, après décapage à l'acide nitrique et preoxydation thermique, dans les mêmes conditions que pour l'exemple No 1, traités par décharge plasma micro-ondes, à l'aide d'un mélange Ar-3%H₂ injecté à 10 l/mn, chaque échantillon étant porté à une température de 150 °C, et la puissance utilisée pour créer le plasma étant de 200 W. Le temps nécessaire pour décaper chaque échantillon était alors voisin de 2 mn, donc un temps de traitement plus long que ce qui était obtenu dans le cadre de l'exemple No 1, pour un échantillon plus petit. On peut de plus rappeler que cette méthode de plasma micro-ondes présente par ailleurs l'inconvénient de mettre en oeuvre (comme son nom l'indique) un plasma, donc des espèces électriquement chargées, ce qui peut poser problème quand des composants électroniques sensibles sont présents.

Pour le troisième exemple de mise en oeuvre, une procédure identique à celle de l'exemple No 1 a été suivie, exceptée pour l'étape de préoxydation des échantillons. Cette fois l'oxydation a été effectuée en suivant une norme classique de pollution des circuits en électronique, par la méthode dite "de l'eau bouillante" selon laquelle après nettoyage chimique (acide nitrique), les substrats sont plongés durant 10 mn dans l'eau bouillante. Cette oxydation est beaucoup plus "douce" que la méthode thermique, et plus représentative des niveaux d'oxydation couramment rencontrés sur les circuits électroniques avant brasage ou étamage.

L'observation des échantillons après traitement a montré ici encore un excellent état de surface, les échantillons retrouvant ici encore leur couleur saumon initiale.

Pour un quatrième exemple de mise en oeuvre, on a évalué les échantillons de cuivre obtenus par l'exemple No 3 (nettoyage acide nitrique, préoxidation à l'eau bouillante, traitement selon l'invention) en les soumettant à un processus de mouillage par de la soudure étain-plomb dans une machine du type étamage à la vague, l'étape de préfluxage chimique généralement présente à l'entrée de ces machines ayant été volontairement omise.

L'observation du dépôt de soudure effectué dans de telles conditions a montré un excellent résultat de mouillage du dépôt sur le cuivre (comme le montrait un faible angle de contact), une bonne continuité du dépôt et un bon état de surface de ce dépôt (démontré par son aspect de miroir).

Ce quatrième exemple de mise en oeuvre a ainsi démontré la possibilité d'effectuer de tels dépôts de soudure (que ce soit avec un objectif de brasage ou encore d'étamage) sans utiliser les classiques pre-fluxage chimiques qui entraînent la nécessité d'effectuer ultérieurement une opération de nettoyage après brasage.

Pour un cinquième exemple, comparatif, les échantillons de l'exemple No 3, ont été non pas traités par le procédé selon l'invention, mais simplement décapés à l'aide d'une solution à 20 % d'acide nitrique, cela après l'étape de preoxydation à l'eau bouillante, et avant l'évaluation de ces échantillons par étamage.

Les résultats obtenus ici ont été nettement moins probants, le dépôt d'étain-plomb étant discontinu (présence d'îlots) et l'angle de contact étant plus élevé que dans le cas précédent, ces résultats étant le signe d'un décapage moins efficace par l'acide nitrique que celui qui était obtenu selon l'invention dans le cadre de l'exemple No 4.

Pour un sixième exemple de mise en oeuvre de l'invention, on a utilisé des circuits du type circuit imprimé époxy, les pistes conductrices de ces circuits ayant été préétamées, des composants électroniques (du type résistif, capacitif, SOT 23, et SO) ayant été fixés, par un point de colle, sur les plots conducteurs adéquats du circuit.

Ces circuits ont dans un premier temps subi un traitement de fluxage selon l'invention, tel que celui décrit dans le cadre de l'exemple 1, la distance entre le circuit et la sortie de gaz de l'appareil de formation d'espèces gazeuses instables ou excitées étant de l'ordre de 10 mm. Dans un second temps, l'opération de fluxage ainsi réalisée selon l'invention a été évaluée par une opération de brasage des composants (donc de réalisation des liaisons électriques) par passage des circuits dans une machine classique de brasage à la vague, l'étape de préfluxage chimique présente à l'entrée de la machine ayant été volontairement omise. L'observation des joints de soudure en sortie de machine ont démontré un excellent mouillage, et de ce fait confirmé la possibilité de réaliser selon l'invention un fluxage par voie sèche, évitant l'utilisation d'un fluxage classique par voie chimique qui nécessite généralement en aval une opération de nettoyage des circuits après brasage pour éliminer les résidus de flux.

Quoique la présente invention ait été décrite en relation avec des modes de réalisation particuliers, elle ne s'en trouve pas limitée pour autant mais est au contraire susceptible de modifications et de variantes qui apparaîtront à l'homme de l'art dans le cadre des revendications ci-après.

## Revendications

1. Procédé de fluxage par voie sèche d'une surface métallique avant brasage ou étamage à l'aide d'un alliage, dans lequel :
a) on dispose d'au moins un appareil (11,4,12) de formation d'espèces gazeuses excitées ou instables, muni d'une entrée de gaz (5,20), et d'une sortie de gaz (6,21), apte à admettre en son entrée de gaz un mélange gazeux initial et à produire en sa sortie de gaz un mélange gazeux primaire, comprenant des espèces gazeuses excitées ou instables et substantiellement dépourvu d'espèces électriquement chargées, résultant de la transformation du mélange gazeux initial à l'intérieur de l'appareil ;
b) on transforme dans ledit appareil un mélange gazeux initial (7) comprenant un gaz inerte et/ou un gaz réducteur et/ou un gaz oxydant ;
c) on traite la surface à fluxer, à une pression voisine de la pression atmosphérique, par une atmosphère gazeuse de traitement (30) obtenue à partir du mélange gazeux primaire, obtenu à la sortie de gaz dudit appareil, résultant de la transformation réalisée durant l'étape b).

2. Procédé selon la revendication 1, caractérisé en ce que ladite atmosphère gazeuse de traitement est obtenue à partir dudit mélange gazeux primaire et d'un mélange gazeux adjacent (9,10) qui n'a pas transité par le dit appareil.

3. Procédé selon la revendication 2, caractérisé en ce que le mélange adjacent contient du silane SiH₄.

4. Procédé selon l'une des revendications 1 à 3, caractérisé en ce que la pièce (1) comportant la surface métallique à traiter est amenée en regard de la sortie (6) de gaz du dit appareil (4), par un système de convoyage (2) traversant un espace intérieur (31) délimité par une structure de capotage (30), isolé de l'atmosphère environnante, ladite structure étant raccordée de façon étanche au dit appareil ou incluant le dit appareil.

5. Procédé selon l'une des revendications 1 à 3, caractérisé en ce que la pièce (1) comportant la surface métallique à traiter est amenée en regard des sorties de gaz de plusieurs appareils placés en parallèle sur la largeur de la pièce et/ou successivement en regard des sorties de gaz de plusieurs appareils (11, 4, 12) placés en série, par un système de convoyage (2) traversant un espace intérieur (31) délimité par une structure de capotage (30), isolé de l'atmosphère environnante, ladite structure étant raccordée de façon étanche aux dits appareils ou incluant les dits appareils.

6. Procédé selon la revendication 4 ou 5, caractérisé en ce que le dit appareil, dans lequel est transformé ledit mélange gazeux initial, est le siège d'une décharge électrique créée entre une première électrode (14) et une seconde électrode (17), une couche (16) d'un matériau diélectrique étant disposée sur la surface d'au moins une des électrodes (17), en regard de l'autre électrode, et en ce que le dit mélange gazeux initial traverse la décharge transversalement aux électrodes.

7. Procédé selon la revendication 6, caractérisé en ce que l'énergie mise en oeuvre dans le dit appareil, ramenée à l'unité de surface de diélectrique est supérieure à 1W/cm², préférentiellement supérieure à 10W/cm².

8. Procédé selon la revendication 5, dans son rattachement à la revendication 1, caractérisé en ce que l'on réalise un zonage de l'atmosphère de traitement rencontrée successivement par la pièce à traiter le long du convoyeur, de la façon suivante : au moins un des appareils (11, 4, 12) de formation d'espèces gazeuses excitées ou instables transforme un mélange gazeux initial (7) différent de celui transformé par l'appareil le précédant dans ladite structure (3).

9. Procédé selon la revendication 5 dans son rattachement à la revendication 2, caractérisé en ce que l'on réalise un zonage de l'atmosphère de traitement rencontrée successivement par la pièce à traiter le long du convoyeur, de la façon suivante :
a) au moins un des appareils (11, 4, 12) de formation d'espèces gazeuses excitées ou instables transforme un mélange gazeux initial (7) différent de celui transformé par l'appareil le précédant dans ladite structure (3), et/ou
b) le mélange gazeux adjacent (9, 10) mis en oeuvre au niveau d'au moins un des appareils (11, 4, 12) de formation d'espèces gazeuses excitées ou instables est différent de celui mis en oeuvre au niveau de l'appareil le précédant dans ladite structure (3).

10. Procédé selon la revendication 9, caractérisé en ce que les étapes a) et b) ont lieu au niveau d'un même appareil.

11. Procédé selon l'une des revendications 4 à 10, caractérisé en ce qu'en sortie de ladite structure, la pièce entre dans une machine où est effectuée la dite opération de brasage ou d'étamage, la pièce étant, entre la sortie de ladite structure et l'entrée de la dite machine, maintenue sous atmosphère protectrice.

12. Procédé selon l'une des revendications 4 à 10, caractérisé en ce que la dite opération de brasage ou d'étamage est réalisée au sein de la même dite structure, en aval du dit appareil.

13. Procédé selon l'une des revendications 1 à 12, caractérisé en ce que la pièce comportant la surface métallique à traiter est un circuit électronique.

14. Procédé selon la revendication 13, caractérisé en ce que le circuit est fluxé sur une seule de ses deux faces.

15. Procédé selon la revendication 13, caractérisé en ce qu'on dispose les appareils requis en regard de chaque face du circuit, de façon à fluxer le circuit sur ses deux faces.

16. Procédé selon l'une des revendications 1 à 15, caractérisé en ce que ledit fluxage intervient avant une opération de brasage à la vague.

17. Procédé selon l'une des revendications 1 à 15, caractérisé en ce que ledit fluxage intervient avant une opération de brasage par refusion.

18. Procédé selon l'une des revendications 1 à 15, caractérisé en ce que ledit fluxage intervient avant une opération de brasage de puces nues sur un support.

19. Procédé selon l'une des revendications 1 à 15, caractérisé en ce que ledit fluxage intervient avant une opération de brasage d'un circuit dans un fond de boîtier d'encapsulation du circuit considéré.

20. Procédé selon l'une des revendications 1 à 15, caractérisé en ce que ledit fluxage intervient avant une opération de brasage intervenant lors d'une procédure de fermeture d'un boîtier d'encapsulation de composants électroniques.

21. Procédé selon l'une des revendications 1 à 12, caractérisé en ce que ledit fluxage intervient avant une opération d'étamage.

22. Dispositif de fluxage par voie sèche de surface métallique avant brasage ou étamage, pour la mise en oeuvre du procédé selon l'une des revendications 1 à 12, comprenant une structure de capotage (3), définissant un espace intérieur (31) traversé par des moyens de convoyage (2) des pièces (1) comportant la surface métallique à fluxer et isolé de l'atmosphère environnante, entourant ou se raccordant de façon étanche à un ou plusieurs appareils (4, 11, 12) de formation d'espèces gazeuses excitées ou instables montés en série et/ou parallèle, comprenant au moins un passage de gaz tubulaire (18) ayant un axe, le passage de gaz tubulaire étant formé entre une électrode extérieure (14) et une électrode intérieure (17), l'une au moins des électrodes comportant, en regard de l'autre, un revêtement diélectrique (16), les électrodes étant reliées à une source haute tension et haute fréquence (27), l'électrode extérieure (14) entourant le diélectrique (16) et comportant une entrée (20) de gaz dit initial et une sortie (21) de gaz dit primaire allongées , parallèles à l'axe et sensiblement diamétralement opposées, ladite sortie de gaz débouchant dans l'espace intérieur (31) de ladite structure de capotage (3).

23. Dispositif selon la revendication 22, caractérisé en ce que la dite structure est munie d'au moins un moyen d'injection (9, 10, 13) d'un gaz dit adjacent ne transitant pas par le ou les dits appareils.

## Claims

1. Process for dry fluxing a metal surface prior to soldering or tinning with the aid of an alloy, wherein :
a) at least one apparatus (11, 4, 12) is used for forming excited or unstable gaseous species, provided with a gas inlet (5, 20) and a gas outlet (6, 21), able to admit at its gas inlet an initial gaseous mixture and to produce at its gas outlet a primary gaseous mixture, containing excited or unstable gaseous species and substantially free from electrically charged species, resulting from the conversion of the initial gaseous mixture within the apparatus;
b) an initial gaseous mixture (7) containing an inert gas and/or a reducing gas and/or an oxidizing gas is converted in the said apparatus;
c) The surface to be fluxed, is treated, at a pressure close to atmospheric pressure, with a gaseous treatment atmosphere (30) obtained from the primary gaseous mixture, obtained at the gas outlet from the said apparatus, resulting from the conversion carried out during step b).

2. Process according to claim 1, characterized in that the said gaseous treatment atmosphere was obtained from the said primary gaseous mixture and an adjacent gaseous mixture (9,10) which has not passed through the said apparatus.

3. Process according to claim 2, characterized in that the adjacent mixture contains silane SiH₄.

4. Process according to one of claims 1 to 3, characterized in that the part (1) having the metal surface to be treated is brought opposite the gas outlet (6) of the said apparatus (4), by a conveyor system (2) passing through an inner space (31) delimited by a cowling structure (30), isolated from the surrounding atmosphere, the said structure being connected in a sealed manner to the said apparatus or including the said apparatus.

5. Process according to one of claims 1 to 3, characterized in that the part (1) having the metal surface to be treated is brought opposite the gas outlets of several apparatuses placed in parallel over the width of the part and/or successively opposite the gas outlets of several apparatuses (11, 4, 12) placed in series, by a conveyor system (2) passing through an inner space (31) delimited by a cowling structure (30), isolated from the surrounding atmosphere, the said structure being connected in a sealed manner to the said apparatuses or including the said apparatuses.

6. Process according to claim 4 or 5, characterized in that the said apparatus, in which the said initial gaseous mixture is converted, is the source of an electric discharge created between a first electrode (14) and a second electrode (17), a layer (16) of a dielectric material being disposed on the surface of at least one of the electrodes (17), opposite the other electrode, and in that the said initial gaseous mixture passes through the discharge transversely to the electrodes.

7. Process according to claim 6, characterized in that the energy used in the said apparatus, reduced to a unit area of the dielectric, is greater than 1W/cm², preferably greater than 10W/cm².

8. Process according to claim 5, in its attachment to claim 1, characterized in that the treatment atmosphere encountered successively by the part to be treated along the conveyor is divided into zones in the following manner : at least one of the apparatuses (11, 4, 12) for forming excited or unstable gaseous species converts an initial gaseous mixture (7) different from that converted by the preceding apparatus in the said structure (3).

9. Process according to claim 5, in its attachment to claim 2, characterized in that the treatment atmosphere encountered successively by the part to be treated along the conveyor is divided into zones in the following manner :
a) at least one of the apparatuses (11, 4, 12) for forming excited or unstable gaseous species converts an initial gaseous mixture (7) different from that converted by the preceding apparatus in the said structure (3), and/or
b) the adjacent gaseous mixture (9, 10) used in at least one of the apparatuses (11, 4, 12) for forming excited or unstable species is different from that used in the preceding apparatus in the said structure (3).

10. Process according to claim 9, characterized in that the steps a) and b) take place in the same apparatus.

11. Process according to one of claims 4 to 10, characterized in that on leaving the said structure, the part enters a machine where the said soldering or tinning operation is carried out, the part being, between the outlet from the said structure and the inlet of the said machine, maintained under a protective atmosphere.

12. Process according to one of claims 4 to 10, characterized in that the said soldering or tinning operation is carried out within the same said structure, downstream from the said apparatus.

13. Process according to one of claims 1 to 12, characterized in that the part having the metal surface to be treated is an electronic circuit.

14. Process according to claim 13, characterized in that the circuit is fluxed on only one of its two faces.

15. Process according to claim 13, characterized in that the apparatuses required are arranged opposite each face of the circuit, so as to flux the circuit on its two faces.

16. Process according to one of claims 1 to 15, characterized in that the said fluxing takes place before a wave soldering operation.

17. Process according to one of claims 1 to 15, characterized in that the said fluxing takes place before a soldering operation by refusion.

18. Process according to one of claims 1 to 15, characterized in that the said fluxing takes place before a soldering operation of bare chips on a support.

19. Process according to one of claims 1 to 15, characterized in that the said fluxing takes place before a soldering operation of a circuit in the bottom of an encapsulating box of the circuit considered.

20. Process according to one of claims 1 to 15, characterized in that the said fluxing takes place before a soldering operation carried out during a process of closing a box for encapsulating electronic components.

21. Process according to one of claims 1 to 12, characterized in that the said fluxing takes place before a tinning operation.

22. Device for dry fluxing a metal surface before soldering or tinning, for putting into practice the process according to one of claims 1 to 12, including a cowling structure (3) defining an inner space (31) traversed by a means (2) for conveying parts (1) having the metal surface to be fluxed and isolated from the surrounding atmosphere, surrounding or being connected in a sealed manner to one or more apparatuses (4,11,12) for forming excited or unstable gaseous species, mounted in series and/or parallel, having at least one tubular gas passage (18) having an axis, the passage of the tubular gas being formed between an outer electrode (14) and an inner electrode (17) at least one of the electrodes having, opposite the other, a dielectric coating (16), the electrodes being connected to a high voltage, high frequency source (27), the outer electrode (14) surrounding the dielectric (16) and having a so-called initial gas inlet (20) and a so-called primary gas outlet (21) extended parallel to the axis and substantially diametrically opposed, the said gas outlet emerging into the inner space (31) of the said cowling structure (3).

23. Device according to claim 22, characterized in that the said structure is provided with at least one means (9,10,13) for injecting a said adjacent gas not passing through the said apparatus or apparatuses.

## Patentansprüche

1. Verfahren zum Trockenfluxen einer metallischen Oberfläche vor dem Löten oder Verzinnen mit Hilfe einer Legierung, in welchem:
a) wenigstens ein Gerät (11,4,12) zur Bildung von angeregten oder instabilen Gasspezies angeordnet wird, das mit einem Gaseinlaß (5,20) und einen Gasauslaß (6,21) versehen ist, und geeignet ist, an seinem Gaseinlaß ein Ausgangs-Gasgemisch aufzunehmen und an seinem Gasauslaß ein primäres Gasgemisch auszustoßen, welches angeregte oder instabile Gasspezies enthält und im wesentlichen frei ist von elektrisch geladenen Spezies und aus der Umwandlung des Ausgangs-Gasgemisches im Innern des Geräts hervorgeht;
b) ein Ausgangs-Gasgemisch (7), welches ein inertes und/oder ein reduzierendes Gas und/oder ein oxidierendes Gas umfaßt, in dem genannten Gerät umgewandelt wird;
c) die zu fluxende Oberfläche bei einem dem atmosphärischen Druck benachbarten Druck mittels einer Behandlungs-Gasatmosphäre (30) behandelt wird, die aus dem primären Gasgemisch erhalten wird, das am Gasauslaß des genannten Geräts erhalten wird und aus der während der Stufe b) durchgeführten Umwandlung hervorgeht.

2. Verfahren nach Anspruch 1, dadurch gekennzeichnet, daß die genannte Behandlungs-Gasatmosphäre aus dem genannten primären Gasgemisch und einem angrenzenden Gasgemisch (9,10), das nicht durch das genannte Gerät gefördert wurde, erhalten wird.

3. Verfahren nach Anspruch 2, dadurch gekennzeichnet, daß das angrenzende Gemisch Silan SiH₄ enthält.

4. Verfahren nach einem der Ansprüche 1 bis 3, dadurch gekennzeichnet, daß das Werkstück (1), welches die zu behandelnde metallische Oberfläche aufweist, in Position gegenüber Gasauslaß (6) des genannten Geräts (4) mittels eines Fördersystems (2) geführt wird, welches einen inneren, durch einen Verkleidungs-Aufbau (30) begrenzten Raum (31) durchquert, der von der umgebenden Atmosphäre isoliert ist, wobei der genannte Aufbau mit dem genannten Gerät hermetisch zusammengeschlossen ist oder das genannte Gerät umschließt.

5. Verfahren nach einem der Ansprüche 1 bis 3, dadurch gekennzeichnet, daß das Werkstück (1), welches die zu behandelnde metallische Oberfläche aufweist, in Position gegenüber den Gasauslässen mehrerer Geräte, die parallel über die Breite des Werkstücks angeordnet sind, und/oder aufeinanderfolgend in Position gegenüber den Gasauslässen mehrerer Geräte (11,4,12), die in Reihe angeordnet sind, mittels eines Fördersystems (2) geführt wird, welches einen inneren, durch einen Verkleidungs-Aufbau (30) begrenzten Raum (31) durchquert, der von der umgebenden Atmosphäre isoliert ist, wobei der genannte Aufbau mit den genannten Geräten hermetisch zusammengeschlossen ist oder die genannten Geräte umschließt.

6. Verfahren nach einem der Ansprüche 4 oder 5, dadurch gekennzeichnet, daß das genannte Gerät, in dem das genannte Ausgangs-Gasgemisch umgewandelt wird, der Ort einer elektrischen Entladung ist, die zwischen einer ersten Elektrode (14) und einer zweiten Elektrode (17) erzeugt wird, wobei eine Schicht (16) eines dielektrischen Materials auf der Oberfläche wenigstens einer der Elektroden (17) gegenüber der anderen Elektrode angeordnet ist, und dadurch, daß das genannte Ausgangs-Gasgemisch die Entladung quer zu den Elektroden durchströmt.

7. Verfahren nach Anspruch 6, dadurch gekennzeichnet, daß die in dem genannten Gerät eingesetzte Energie, bezogen auf die Flächeneinheit des Dielektrikums, oberhalb 1W/cm² und bevorzugt oberhalb 10W/cm² liegt.

8. Verfahren nach Anspruch 5 in dessen Verbindung mit Anspruch 1, dadurch gekennzeichnet, daß eine Zoneneinteilung der Behandlungs-Atmosphäre, die aufeinanderfolgend auf das zu behandelnde Werkstück längs des Förderbands auftrifft, in folgender Weise durchgeführt wird: wenigstens eines der Geräte (11,4,12) zur Bildung von angeregten oder instabilen Gasspezies wandelt ein Ausgangs-Gasgemisch (7) um, das sich von demjenigen unterscheidet, das mittels des vorhergehenden Geräts in dem genannten Aufbau (3) umgewandelt wird.

9. Verfahren nach Anspruch 5 in dessen Verbindung mit Anspruch 2, dadurch gekennzeichnet, daß eine Zoneneinteilung der Behandlungs-Atmosphäre, welche aufeinanderfolgend auf das zu behandelnde Werkstück längs des Förderbands auftrifft, in folgender Weise durchgeführt wird:
a) Wenigstens eines der Geräte (11,4,12) zur Bildung von angeregten oder instabilen Gasspezies wandelt ein Ausgangs-Gasgemisch (7) um, das sich von demjenigen unterscheidet, das mittels des vorhergehenden Geräts in dem genannten Aufbau (3) umgewandelt wird, und/oder
b) das angrenzende Gasgemisch (9,10), das auf gleicher Höhe mit wenigstens einem der Geräte (11,4,12) zur Bildung von angeregten oder instabilen Gasspezies eingesetzt wird, unterscheidet sich von demjenigen, das auf gleicher Höhe mit dem vorhergehenden Gerät in dem genannten Aufbau (3) eingesetzt wird.

10. Verfahren nach Anspruch 9, dadurch gekennzeichnet, daß die Stufen a) und b) auf gleicher Höhe im selben Gerät stattfinden.

11. Verfahren nach einem der Ansprüche 4 bis 10, dadurch gekennzeichnet, daß das Werkstück am Ausgang des genannten Aufbaus in eine Maschine eintritt, in welcher der genannte Löt- oder Verzinnungsprozeß durchgeführt wird, wobei das Werkstück zwischen dem Ausgang des genannten Aufbaus und dem Eingang der genannten Maschine unter Schutz-Atmosphäre gehalten wird.

12. Verfahren nach einem der Ansprüche 4 bis 10, dadurch gekennzeichnet, daß der genannte Löt- oder Verzinnungsprozeß innerhalb desselben genannten Aufbaus unterhalb des genannten Geräts durchgeführt wird.

13. Verfahren nach einem der Ansprüche 1 bis 12, dadurch gekennzeichnet, daß das Werkstück, das die zu behandelnde metallische Oberfläche aufweist, eine elektronische Schaltung ist.

14. Verfahren nach Anspruch 13, dadurch gekennzeichnet, daß die Schaltung nur auf einer ihrer beiden Seiten gefluxt wird.

15. Verfahren nach Anspruch 13, dadurch gekennzeichnet, daß die erforderlichen Geräte in Position gegenüber jeder Seite der Schaltung in der Weise angeordnet werden, daß die Schaltung auf ihren beiden Seiten gefluxt wird.

16. Verfahren nach einem der Ansprüche 1 bis 15, dadurch gekennzeichnet, daß das genannte Fluxen vor einem Wellenlötprozeß stattfindet.

17. Verfahren nach einem der Ansprüche 1 bis 15, dadurch gekennzeichnet, daß das genannte Fluxen vor einem Umschmelzlötprozeß stattfindet.

18. Verfahren nach einem der Ansprüche 1 bis 15, dadurch gekennzeichnet, daß das genannte Fluxen vor einem Prozeß zum Löten von Nacktchips auf einem Träger stattfindet.

19. Verfahren nach einem der Ansprüche 1 bis 15, dadurch gekennzeichnet, daß das genannte Fluxen vor einem Prozeß zum Löten einer Schaltung im Boden eines Gehäuses zur Verkapselung der in Betracht gezogenen Schaltung stattfindet.

20. Verfahren nach einem der Ansprüche 1 bis 15, dadurch gekennzeichnet, daß das genannte Fluxen vor einem Lötprozeß erfolgt, der bei einem Prozeß des Verschließens eines Gehäuses zur Verkapselung von elektronischen Komponenten stattfindet.

21. Verfahren nach einem der Ansprüche 1 bis 12, dadurch gekennzeichnet, daß das genannte Fluxen vor einem Verzinnungsprozeß stattfindet.

22. Vorrichtung zum Trockenfluxen einer metallischen Oberflächen vor dem Löten oder Verzinnen zur Ausführung des Verfahrens gemäß einem der Ansprüche 1 bis 12, welche einen Verkleidungs-Aufbau (3) umfaßt, der einen inneren Raum (31) definiert, welcher durchquert wird von Mitteln zur Förderung (2) von Werkstücken (1), die die zu fluxende metallische Oberfläche aufweisen, und welcher von der umgebenden Atmosphäre isoliert ist und hermetisch ein oder mehrere Geräte (4,11,12) zur Bildung von angeregten oder instabilen Gasspezies, die in Reihe und/oder parallel angeordnet sind und wenigstens einen röhrenförmigen Gasdurchgang (18) mit einer Achse umfassen, umgibt oder mit diesen zusammengeschlossen ist, wobei der röhrenförmige Gasdurchgang zwischen einer äußeren (14) und einer inneren Elektrode (17) gebildet wird, wenigstens eine der Elektroden eine der anderen gegenüberliegende dielektrische Umkleidung (16) aufweist, die Elektroden an eine Hochspannungs- und Hochfrequenz-Quelle (27) angeschlossen sind, die äußere Elektrode (14) das Dielektrikum (16) umgibt und einen Einlaß (20) für das genannte Ausgangs-Gas und einen Auslaß (21) für das genannte primäre Gas aufweist, die parallel zur Achse verlängert sind und sich in etwa diametral gegenüberliegen, wobei der genannte Gasauslaß in den inneren Raum (31) des genannten Verkleidungs-Aufbaus (3) mündet.

23. Vorrichtung nach Anspruch 22, dadurch gekennzeichnet, daß der genannte Aufbau mit wenigstens einem Mittel zur Einspeisung (9,10,13) eines genannten angrenzenden Gases, welches das oder die genannten Geräte nicht durchströmt, versehen ist.
